(19) Europäisches Patentamt
European Patent Office
Office européen des brevets

(11) EP 0 617 507 B1

(12) EUROPÄISCHE PATENTSCHRIFT

(45) Veröffentlichungstag und Bekanntmachung des Hinweises auf die Patenterteilung:
22.07.1998 Patentblatt 1998/30

(51) Int Cl.⁶: H03D 3/00

(21) Anmeldenummer: 94103829.1

(22) Anmeldetag: 12.03.1994

(54) **Verfahren zur Demodulation von frequenzmodulierten Signalen**

Frequency modulated signals demodulation method

Procédé de démodulation de signaux modulés en fréquence

(84) Benannte Vertragsstaaten:
AT CH ES GB IT LI

(30) Priorität: 25.03.1993 DE 4309684

(43) Veröffentlichungstag der Anmeldung:
28.09.1994 Patentblatt 1994/39

(73) Patentinhaber: ROBERT BOSCH GMBH
70442 Stuttgart (DE)

(72) Erfinder: Göckler, Heinz, Dr.
D-71522 Backnang (DE)

(56) Entgegenhaltungen:
EP-A- 0 148 018          EP-A- 0 486 095
DE-A- 3 841 388

• SIGNAL PROCESSING, Bd.9, Nr.4, Dezember 1985, NORTH-HOLLAND Seiten 263 - 267 KAMMEYER 'EQUALIZATION PROBLEMS IN A DIGITAL FM RECEIVER'

**Beschreibung**

Die Erfindung betrifft ein Verfahren zur Demodulation von frequenzmodulierten Signalen gemäß Oberbegriff des Anspruches 1. Solche digitale Verfahren zur Demodulation von kontinuierlich modulierten FM-Signalen, also nicht FSK, welche zum eigentlichen Demodulationsprozeß komplexwertige Signale benötigen und verarbeiten, sind bekannt, beispielsweise durch den Aufsatz "Equalization Problems in a digital FM Receiver" von Kammeyer in Signal Processing 9 (1985) Seiten 263-276, wobei es sich um einen sogenannten Verzögerungsdemodulator handelt.

Aus der Dissertation "Die Demodulation frequenzumgetasteter Signale mit Bandbreiten in der Größenordnung der Mittenfrequenz" von Ruopp, Universität Stuttgart 1975 ist die Blockstruktur eines mit Differentiation arbeitenden Demodulationsverfahren bekannt geworden.

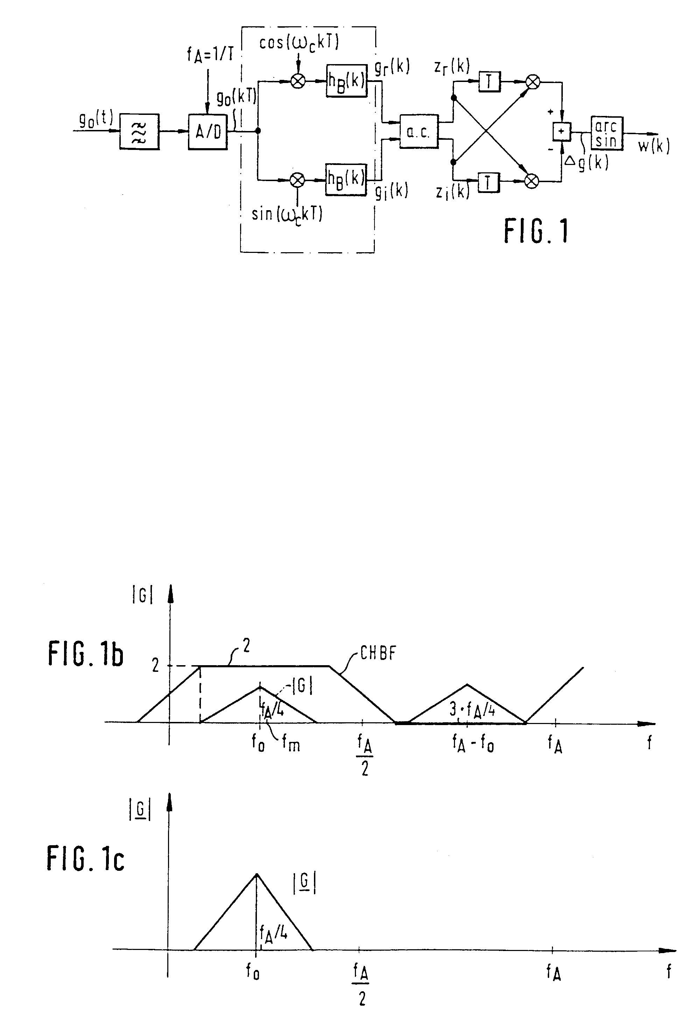

Bei all diesen Verfahren ist es erforderlich, aus dem urprünglich reellwertigen FM-Eingangssignal $g_o(t)$ ein komplexwertiges Signal abzuleiten in Form einer Normal- und einer Quadraturkomponente (Real- und Imaginärteil). Diese Komponenten werden erzeugt, indem das abgetastete Eingangssignal mit zwei zueinander orthogonalen Trägersignalen multipliziert wird (Mischer) und anschließend mittels zweier nachgeschalteter identischer Tiefpässe zur Unterdrückung unerwünschter Mischprodukte gefiltert werden. Die dazu notwendige Schaltungsanordnung ist in Figur 1 strichliert umrandet.

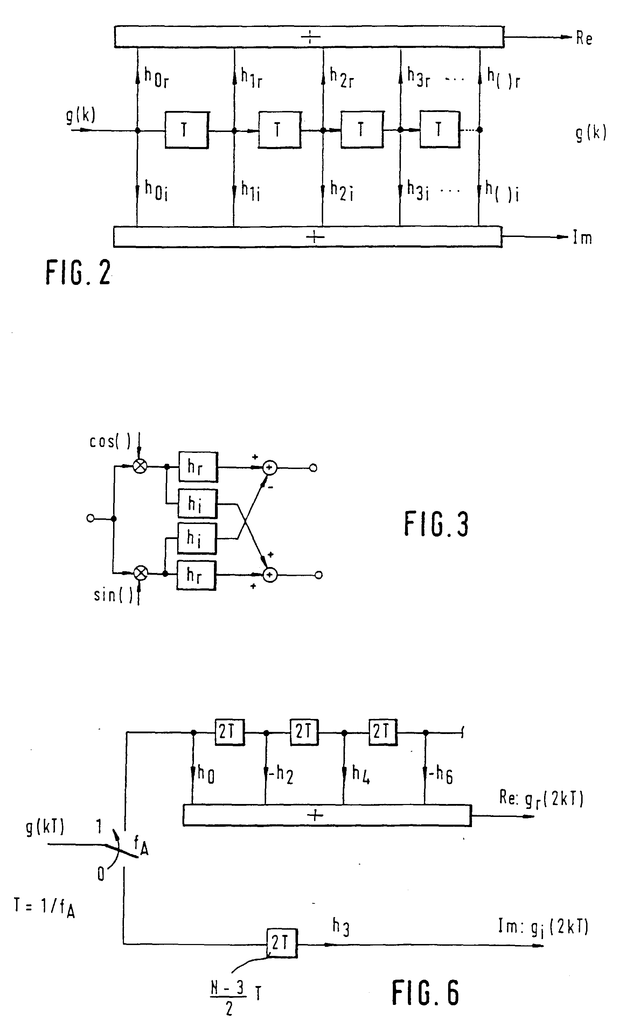

Wenn die Filterkombination $h_B$ zusätzlich die Aufgabe übernehmen soll, den bezüglich der Mittenfrequenz unsymmetrischen Frequenzgang des analogen Vorfilters zu entzerren, dann enthält der gestrichelte Block der Figur 1 vier Teilfilter, wie in Figur 3 gezeigt wird.

Der vorliegenden Erfindung lag die Aufgabe zugrunde, ein Verfahren der eingangs genannten Art anzugeben, welches in der Lage ist, Demodulationssignale gleicher oder sogar höherer Qualität zu erzeugen unter Verminderung des Aufwandes.

Diese Aufgabe wurde gelöst mit den Mitteln des Anspruches 1. Vorteilhafte Ausgestaltungen ergeben sich durch die Unteransprüche.

Das erfindungsgemäße Demodulationsverfahren erfordert wesentlich weniger Schaltungsaufwand und liefert qualitativ mindestens gleichwertige Demodulationsprodukte. Das Verfahren ist auch dann anwendbar, wenn beliebige Frequenzverschiebung gewünscht wird.

Es folgt nun die Beschreibung anhand der Figuren.

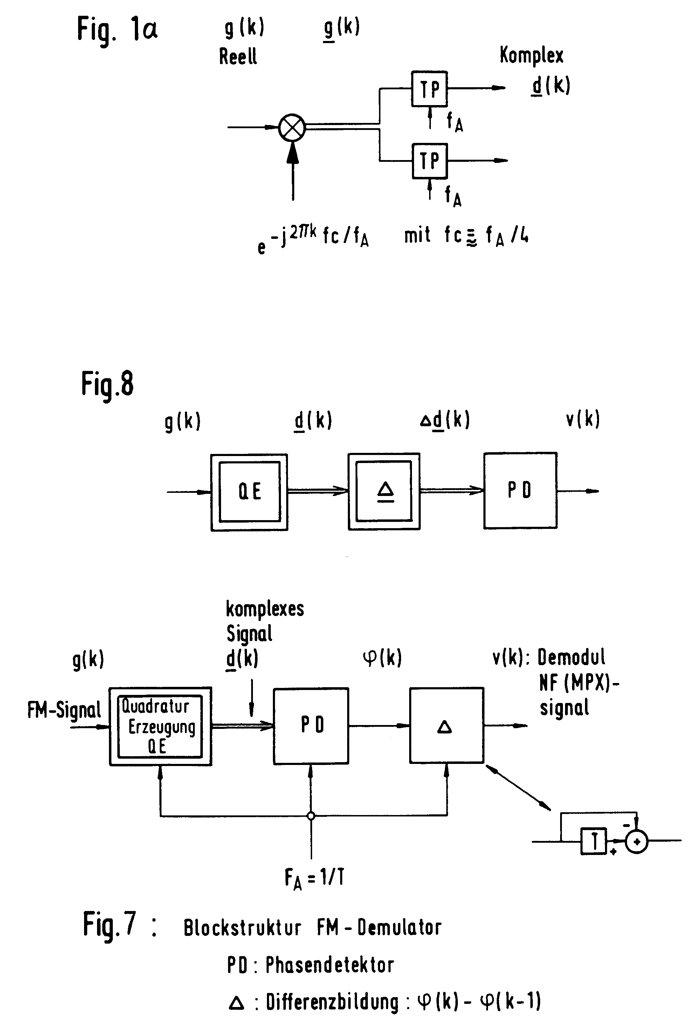

Die Figur 1 zeigt das grundlegende Blockdiagramm für einen digitalen FM-Demodulator nach Kammeyer; die Figur 1a zeigt eine andere Darstellung für die Quadraturerzeugung QE in dem strichlierten Block der Figur 1, wie sie aber auch in den Anordnungen der Figuren 7 und 8 eingesetzt werden kann. Die Figuren 1b und 1c enthalten Spektren aufgetragen über der Frequenz.

Die Figur 3 zeigt die Anordnung aus vier Teilfiltern, wenn die Filterkombination $h_B$ in dem strichlierten Block der Figur 1 zusätzlich die Aufgabe der Entzerrung übernimmt.

Die Figuren 4, 5, 7 und 8 schließlich zeigen Anordnungen, die nach dem erfindungsgemäßen Verfahren arbeiten. In Figur 2 und 6 sind Strukturen für ein Prototypfilter zur Erzeugung eines komplexwertigen Ausgangssignals aus einem reellwertigen Eingangssignal dargestellt.

Im Blockschaltbild gemäß Figur 1 werden die einzelnen Verarbeitungsschritte des eingangsseitigen Empfangssignals gezeigt:

Das durch den Zwischenfrequenzmischer in eine Zwischenfrequenzlage heruntergemischte Empfangssignal $g_0(t)$ wird über ein analoges Vorfilter auf einen Analog/Digitalumsetzer geleitet, abgetastet und anschließend mittels zweier orthogonalen Trägersignale in ein komplexwertiges Signal gewandelt, welches über die Tiefpaßfilterfunktion $h_B$ in beiden Zweigen von störenden Mischprodukten befreit wird. Daran anschließend erfolgt eine Amplitudensteuerung, womit Amplitudenschwankungen ausgeglichen werden, welche dadurch entstehen, daß das von Hause aus unbegrenzte Spektrum eines FM-Signals in technischen Systemen mit eingeschränkten Kanalbandbreiten notwendigerweise bandbegrenzt werden muß. Nach der Amplitudensteuerung folgt der eigentliche Demodulator, hier ein Verzögerungsdemodulator welcher mittels einer komplexen Multiplikation der folgenden Form

$$\Delta g(k) = \mathrm{Im}\,\{\underline{g}(k) \cdot \underline{g}^*(k\text{-}1)\} = \sin\,[w(k)]$$

$$= \sin\,[\varphi(k)\text{-}\ \varphi(k\text{-}1)]$$

das gewünschte Phaseninkrement erzeugt, woraus dann mittels einer anschließenden Arcussinuskonversion das demodulierte Signal w(k) gewonnen wird: $w(k) = \omega_o\,[1 + \alpha \cdot v(k)]$ ($g^*$ ist der konjugiert komplexe Wert zu $\underline{g}$; komplexwertige Größen sind durch Unterstreichungen gekennzeichnet).

In Figur 3 sind die vier Teilfilter zweimal $h_r$ und zweimal hi erkennbar, welche außer der Filterung $h_B$ nach Figur 1 auch noch die Aufgabe der Entzerrung übernehmen, die aufgrund möglicher Verzerrungen des analogen Vorfilters notwendig sein kann. Am meisten störend wirken sich hier Unsymmetrien des Analogfilters bezüglich der Trägerfrequenz des FM-Signals aus.

Die Figuren 1b und 1c zeigen den Frequenzgang eines für die Bandfilterung eingesetzten komplexen Halbbandfilters CHBF zur Umwandlung des reellwertigen Signals g(k) in das zugehörige komplexwertige Signal $\underline{g}$(k), wobei das Halbbandfilter keine Entzerrungsfunktion wahrnimmt. Im folgenden sind die Mittenfrequenzen definiert

$f_m$ :      des komplexen Filters CBF
(bei CHBF $f_m = f_A/4$)

$f_o$ :      des FM-Spektrums

$f_c$ :      Trägerfrequenz des Mischers
($f_c = f_o$ oder $f_c \neq f_o$)

Die Filtermittenfrequenz $f_m$ von CHBF ist gleich einem Viertel der Abtastfrequenz, und der Übergangsbereich des Halbbandfilters liegt symmetrisch zur halben Abtastfrequenz. Im übrigen gilt für dieses komplexe Halbbandfilter, daß der absolute Rippel $\delta p = \delta s$ ist, d.h. die Abweichung von eins im Durchlaßbereich ist identisch gleich der Abweichung von 0 im Sperrbereich. In Figur 1b ist zusätzlich das Spektrum IGI eines reellen mit der Abtastfrequenz $f_A$ abgetasteten Empfangssignals eingezeichnet, dessen Spektrum folglich symmetrisch zur halben Abtastfrequenz ($f_A/2$) ist und das sich aufgrund der Abtastung periodisch wiederholt. Wie in Fig. 1b dargestellt, muß die Bandmittenfrequenz $f_o$ des Spektrums IGI nicht mit der Filtermittenfrequenz $f_m$ übereinstimmen. In Figur 1c ist das Spektrum I$\underline{G}$I des komplexen Signals $\underline{g}(\underline{k})$ gezeichnet, welches bei der Bandmittenfrequenz $f_0$ zentriert liegt; es ist erkennbar, wie sämtliche zu $f_A/2$ spiegelbildlichen Spektralanteile unterdrückt werden.

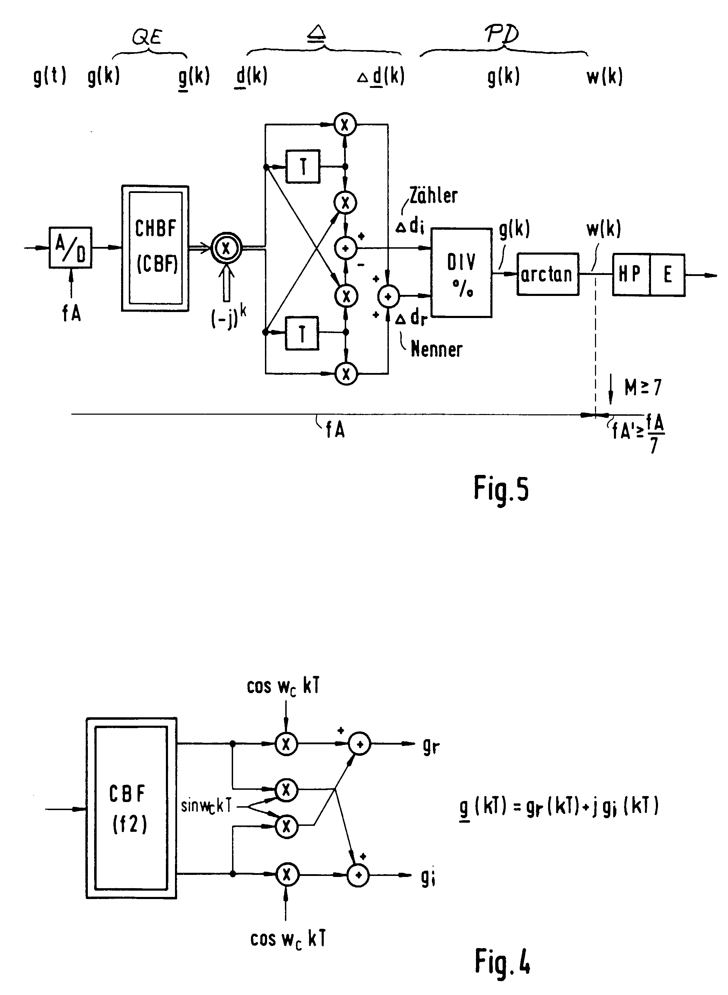

Die Figur 5 zeigt ein allgemeines Blockschaltbild für die erfindungsgemäße Lösung beispielsweise mit einem Arcus-Tangens-Verzögerungsdemodulator. Das Eingangssignal $g_0(t)$ weist ein unendliches Spektrum auf, sodaß bei jeder Wahl der Abtastfrequenz das Abtasttheorem verletzt wird und eine nichtlineare Verzerrung erzeugt wird. Die Abtastrate ist so festzulegen, daß mindestens im Bereich der Carson-Bandbreite B = 300 kHz keine merkliche Überfaltung geschieht. Mittels eines analogen Band- oder Tiefpasses wird das Eingangssignal gefiltert, bevor es dann im Analog-Digital-Umsetzer A/D abgetastet und digitalisiert wird. Die Ausgangsgröße g(k) wird erfindungsgemäß einen komplexen Bandfilter CBF (Filter mit komplexwertigen Koeffizienten) zugeführt, welches wahlweise mit unverminderter oder verminderter Abtastrate (zur Reduktion der Abtastrate) arbeiten kann und das komplexe Signal g'(k) erzeugt, welches mit Hilfe einer komplexen Trägermultiplikation mit $\underline{g}$(k)=$\underline{g}$'(k)•(-j)$^k$ nach Null frequenzverschoben wird. Das Signal $\underline{g}$(k) wird nunmehr einem Verzögerungsdemodulator zugeführt, welcher mittels komplexer Multiplikation das Signal

$$\Delta \underline{g}(k) = \underline{g}(k) \bullet \underline{g}^*(k-1)$$

$$= g_r(k) \bullet g_r(k-1) + g_i(k) \bullet g_i(k-1) + j[g_i(k) \bullet g_r(k-1) - g_r(k)g_i(k-1)]$$

$$= \Delta g_r(k) + j \, \Delta g_i(k)$$

$$= e^{j[\Delta \omega T + \Delta \Omega T \bullet v(k)]} \tag{24}$$

erzeugt.

Das Argument, d.h. die Phase von Gleichung (24) erhält man unmittelbar über eine Arcus-Tangens-Beziehung aus dem Quotienten des Imaginärteils durch den Realteil:

$$g(k) = \frac{\Delta g_i(k)}{\Delta g_r(k)} = \frac{g_i(k) \bullet g_r(k-1) - g_r(k) \bullet g_i(k-1)}{g_r(k) g_r(k-1) + g_i(k) \bullet g_i(k-1)} \tag{25}$$

$$w(k) = \arctan g(k) = \Delta \omega T + \psi(k) - \psi(k-1)$$

$$\approx \Delta \omega T + \Delta \Omega \bullet T \bullet v(k) \tag{26}$$

Für die Eindeutigkeit der Rückgewinnung des Signals gilt für Arcus-Tangens die Einschränkung der Gleichungen

(16a) und (21):

$$-\pi/2 < \Delta\omega T + \Delta\Omega \bullet T \bullet v(k) < \pi/2 \qquad (16a)$$

$$1/t = f_A > 2\pi \bullet 75 \text{ kHz}/ \pi/2 = 300 \text{ kHz} \qquad (21)$$

Im Blockschaltbild der Figur 5 wird die komplexe Multiplikation mit Differenzbildung in dem Block $\underline{\Delta}$ durchgeführt, und in dem nachfolgenden Phasendetektor PD erfolgt die Division DIV mit anschließender Arcus-Tangens-Konversion, dessen Ausgangssignal w(k) noch über einen Hochpaß HP und ggf. über einen Entzerrer E gefiltert bzw. entzerrt wird. Die Schaltung bietet die Vorteile, daß keine Amplitudenregelung benötigt wird und daß die Arcus-Tangens-Funktion für Werte < 1 mit günstigen Reihenentwicklungen realisierbar ist. Für Argumente > 1 kann man mittels der Beziehung Arcus-Tangens-X = $\pi/2$ - Arcus-Tangens 1/X ebenfalls von der Reihenentwicklung für Arcus-Tangens Gebrauch machen.

Das Filter CHBF bzw. CBF im Schaltbild gemäß Figur 5 kann auch mit Abtastratenhalbierung arbeiten; in diesem Fall erfolgt eine komplexe Trägerung mit den einfachen Werten $(-1)^k$, da $f_0$ ungefähr $f_A'/2$ ist, wobei $f_A'$ die Ausgangsabtastfrequenz ist.

**Patentansprüche**

1. Verfahren zur Demodulation von frequenzmodulierten Signalen der Form g(t) = a(t) · Cosinus [$\varphi$(t)] mit der Augenblicksfrequenz $\omega$(t) = d$\varphi$(t)/dt = $\omega_o$[1 + $\alpha$ · v(t)], wobei das Empfangssignal $g_0$(t) mit der Abtastfrequenz $f_A$ = 1/T abgetastet wird zu

$$g_o(k) = a(k) \cdot \cos [\varphi(kT)]$$

$$= a(k) \cdot \cos [\omega_o \, kT + \psi(kT)],$$

mit

$$\Psi(k) \approx \Delta\Omega \cdot T \sum_{-\infty}^{k} v(k),$$

mit dem übertragenen Signal v(k), der Schrittzahl k, der Schritt-Taktlänge T, dem Frequenzhub $\Delta\Omega = \alpha \bullet \omega_o$, der Bezugsfrequenz $\omega_0 = 2\pi f_o$ und mit der durch Bandbegrenzung auf der Übertragungsstrecke bedingten in zeitlicher Abhängigkeit t schwankenden Amplitude a(t) bzw. a(k),
wobei mittels Tiefpaßfilter zur Unterdrückung unerwünschter Spektralanteile gefiltert ($h_B$) wird zu $\underline{g}$(kT) und wobei eine komplexe Multiplikation

$$\Delta\underline{g}(k) = \underline{g}(k) \bullet \underline{g}^*(k-1)$$

$$= g_r(k)\bullet g_r(k-1)+g_i(k)\bullet g_i(k-1)+j[g_i(k)\bullet g_r(k-1)-g_r(k)\bullet g_i(k-1)]$$

$$= \Delta g_r(k)+j\Delta g_i(k)=e^{j[\Delta\omega\bullet T+\Delta\Omega\bullet T\bullet v(k)]}$$

(Verzögerungsdemodulation) durchgeführt und mittels eines Phasendetektors (PD) aus dem Produkt das gewünschte Phaseninkrement w(k) = $\omega_o \cdot \bullet$ [1 + $\alpha$· v(k)] und damit das (zu) übertragen(d)e Signal v(k) gewonnen wird, dadurch gekennzeichnet,
daß das abgetastete Empfangssignal $g_o$(kT) zuerst einer Filterung mit einem Bandfilter unterzogen wird, wobei dieses Filter komplexwertige Koeffizienten $\underline{h}$(k) aufweist (QuadraturErzeugung QE; $\underline{g}'$(k) = $g_0$(kT)$\bullet\underline{h}$(k)), und daß dann mittels komplexer Trägermultiplikation $\underline{g}$(k)=$\underline{g}'$(k).$e^{-j\omega}c^{kT}$ eine Frequenzverschiebung nach f≈0 vorgenommen und die beiden Quadraturkomponenten $g_r$ und $g_i$ dieses verschobenen komplexen Empfangssignals $\underline{g}(k)$ zur komplexen Multiplikaton ($\underline{\Delta}$) verwendet werden.

2. Verfahren nach Anspruch 1, dadurch gekennzeichnet, daß der Quotient aus Real- und Imaginärteil $g_r$, $g_i$ des komplexen Produkts $\underline{g}(k)$ gebildet wird und dieser mittels einer Arcus-Tangens-Konversion arctg $\Delta g_i/\Delta g_r$ bzw. einer Arcus-Cotangens-Konversion in das Phaseninkrement w(k) umgewandelt wird.

3. Verfahren nach Anspruch 1, dadurch gekennzeichnet, daß aus Real- und Imaginärteil mittels eines CORDIC-Algorithmus das gewünschte Phaseninkrement w(k) ermittelt wird.

4. Verfahren zur Demodulation von frequenzmodulierten Signalen der Form g(t) = a(t) · Cosinus $[\varphi(t)]$ mit der Augenblicksfrequenz $\omega(t) = d\varphi(t)/dt = \omega_o[1 + \alpha \cdot v(t)]$, wobei das Empfangssignal $g_0(t)$ mit der Abtastfrequenz $f_A = 1/T$ abgetastet wird zu

$$g_o(k) = a(k) \cdot \cos [\varphi(kT)]$$

$$= a(k) \cdot \cos [\omega_o \, kT + \psi(kT)],$$

mit

$$\Psi(k) \approx \Delta \Omega \cdot T \sum_{-\infty}^{k} v(k) ,$$

mit dem übertragenen Signal v(k), der Schrittzahl k, der Schritt-Taktlänge T, dem Frequenzhub $\Delta\Omega = \alpha \bullet \omega_0$, der Bezugsfrequenz $\omega_0 = 2\pi f_o$ und mit der durch Bandbegrenzung auf der Übertragungsstrecke bedingten in zeitlicher Abhängigkeit t schwankenden Amplitude a(t) bzw. a(k), wobei aus dem abgetasteten Empfangssignal $g_0(k)$ ein Quadratursignal $\underline{g}(k)$ erzeugt (QE) wird, das anschließend mittels Tiefpaßfilter zur Unterdrückung unerwünschter Spektralanteile gefiltert ($h_B$) wird zu $\underline{g}(kT)$ und einem Phasendetektor (PD) zugeführt, der ein Phasensignal $\varphi(k)$ erzeugt, aus dem durch Differenzbildung ($\underline{\Delta}$) das demodulierte (NF)-Signal v(k) = $\varphi(k)$- $\varphi(k-1)$ gewonnen wird, dadurch gekennzeichnet, daß das abgetastete Empfangssignal $g_0(kT)$ zur Quadratursignalerzeugung (QE) zuerst einer Filterung mit einem Bandfilter (CBF) unterzogen wird, das komplexartige Koeffizienten $\underline{h}(k)$ aufweist, daß anschließend mittels komplexer Trägermultiplikation $\underline{g}(k) = \underline{g}'(k) \bullet e^{-j\omega ckT}$ eine Frequenzverschiebung nach f≈0 vorgenommen wird und daß im Phasendetektor aus Realteil $g_r$ und Imaginärteil $g_i$ ein Quotient gebildet wird, der mittels einer Arcus-Tangens-Konversion $\varphi(k)$ = arc tan $g_i/g_r$ bzw. einer Arcus-Cotangens-Konversion $\varphi(k)$ = arc ctg $g_r/g_i$ umgewandelt wird.

5. Verfahren nach einem der vorhergehenden Ansprüche, dadurch gekennzeichnet, daß die komplexwertigen Koeffizienten $\underline{h}(k)$ aus einem Filter mit reellen Koeffizienten h(k) abgeleitet sind.

6. Verfahren nach einem der vorhergehenden Ansprüche, dadurch gekennzeichnet, daß ein im demodulierten Signal mit einem Phaseninkrement w(k) vorhandener Gleichanteil dazu herangezogen wird, um die Frequenz $\omega_c$ für die Trägermultiplikation $\underline{g}(k) = \underline{g}'(k) \, e^{-j\omega ckT}$ auf den korrekten Wert zu regeln zur korrekten Einstellung bei verschwindendem Gleichanteil.

7. Verfahren nach einem der vorhergehenden Ansprüche, dadurch gekennzeichnet, daß die Abtastfrequenz $f_A$ im komplexen Bandfilter halbiert wird und daß die Trägerfrequenz $f_c$ gleich der halbierten Ausgangsabtastfrequenz $f_A'$ ist ($f_c = f'_A/2 = f_A/4$), so daß die Träger-Multiplikation mit $(-1)^k$ erfolgt.

8. Verfahren nach einem der vorhergehenden Ansprüche, dadurch gekennzeichnet, daß das Phaseninkrement w(k) einem Hochpaßfilter (HP) zugeführt wird.

9. Verfahren nach Anspruch 8, dadurch gekennzeichnet, daß das Phaseninkrement w(k) einem Entzerrer (E) zugeführt wird.

10. Verfahren nach einem der vorhergehenden Ansprüche, dadurch gekennzeichnet, daß vor der Analog-Digital-Umsetzung eine Band- oder Tiefpaßfilterung erfolgt.

11. Verfahren nach Anspruch 10, dadurch gekennzeichnet, daß das komplexe Bandfilter (CBF) eine FIR-Struktur mit endlicher Impulsantwort aufweist.

12. Verfahren nach Anspruch 10, dadurch gekennzeichnet, daß das komplexe Bandfilter ein Halbbandfilter CHBF ist, wobei seine Filtermittenfrequenz $f_m$ identisch dem Viertel der Abtastfrequenz $f_A$ ist.

## Claims

1. Method for demodulation of frequency-modulated signals of the form $g(t) = a(t) \cdot \text{Cosine } [\varphi(t)]$ at the instantaneous frequency

$$\omega(t) = d\varphi(t)/dt = w_0[1 + \alpha \cdot v(t)]s$$

the received signal $g_0(t)$ being sampled at the sampling frequency $f_A = 1/T$ to give

$$g_0(k) = a(k) \cdot \cos [\varphi(kT)]$$

$$= a(k) \cdot \cos [\omega_0 \, kT + \psi(kT)]$$

where

$$\psi(k) \approx \Delta\Omega \cdot T \sum_{-\infty}^{k} v(k)$$

with the transmitted signal $V(k)$, the step number k, the step clock duration T, the frequency shift $\Delta\Omega = \alpha \cdot \omega_0$, the reference frequency $\omega_0 = 2\pi f_0$ and the amplitude $a(t)$ or $a(k)$ which fluctuates as a function of time t governed by band limiting on the transmission path, filtering ($h_B$) being carried out by means of low-pass filters to suppress undesirable spectral components to give $g(kT)$ and a complex multiplication

$$\Delta \underline{g}(k) = \underline{g}(k) \cdot \underline{g}^*(k-1)$$

$$= g_r(k) \cdot g_r(k-1) + g_i(k) \cdot g_i(k-1) + j[g_i(k) \cdot g_r(k-1) - g_r(k) \cdot g_i(k-1)]$$

$$= \Delta g_r(k) + j\Delta g_i(k) = e^{j[\Delta\omega \cdot T + \Delta\Omega \cdot T \cdot v(k)]}$$

(delayed demodulation) being carried out and the desired phase increment $w(k) = \omega_0 \cdot \cdot [1 + \alpha \cdot v(k)]$ and thus the transmitted signal, or signal to be transmitted, $v(k)$ being obtained by means of a phase detector (PD) from the product,
characterized in that the sampled received signal $g_o(kT)$ is first subjected to filtering with a bandpass filter, this filter having complex coefficients $\underline{h}(k)$ (quadrature generation QE; $\underline{g}'(k) = g_0(kT) \cdot \underline{h}(k)$), and in that a frequency shift to $f \approx 0$ is then carried out by means of complex carrier multiplication $\underline{g}(k) = \underline{g}'(k) \cdot e^{-j\omega_c kT}$, and the two quadrature components $g_r$ and $g_i$ of this shifted complex received signal $\underline{g}(k)$ are used for complex multiplication ($\underline{\Delta}$).

2. Method according to Claim 1, characterized in that the quotient of the real part and imaginary part $g_r$, $g_i$ of the complex product $\underline{g}(k)$ is formed, and this is converted to the phase increment $w(k)$ by means of an arc tan conversion arc tan $\Delta g_i/\Delta g_r$ or an arc cotan conversion.

3. Method according to Claim 1, characterized in that the desired phase increment $w(k)$ is determined from the real part and imaginary part by means of a CORDIC algorithm.

4.  Method for demodulation of frequency-modulated signals of the form $g(t) = a(t) \cdot$ Cosine $[\varphi(t)]$ at the instantaneous frequency

$$\omega(t) = d\varphi(t)/dt = \omega_0[1 + \alpha \cdot v(t)],$$

the received signal $g_0(t)$ being sampled at the sampling frequency $f_A = 1/T$ to give

$$g_0(k) = a(k) \cdot \cos [\varphi(kT)]$$

$$= a(k) \cdot \cos [\omega_0 kT + \psi (kT)]$$

where

$$\psi (k) \approx {}_\Delta\Omega \cdot T \sum_{-\infty}^{k} v(k)$$

with the transmitted signal $v(k)$, the step number k, the reference frequency $\omega_0 = 2\pi f_0$ and with the amplitude $a(t)$ or $a(k)$ which fluctuates as a function of time T governed by band limiting on the transmission path, a quadrature signal $\underline{g}(k)$ being produced (QE) from the sampled received signal $g_0(k)$, subsequently being filtered ($h_B$) by means of a low-pass filter to suppress undesirable spectral components to give $\underline{g}(kT)$ and being supplied to a phase detector (PD) which produces a phase signal $\varphi(k)$ from which the demodulated (AF) signal $v(k) = \varphi(k)-\varphi(k-1)$ is obtained by a subtraction ($\underline{\Delta}$), characterized in that the sampled received signal $g_0(kT)$ for quadrature signal generation (QE) is first subjected to filtering with a bandpass filter (CBF) which has complex coefficients $\underline{h}(k)$, in that a frequency shift to $f \approx 0$ is then carried out by means of complex carrier multiplication $\underline{g}(k) = \underline{g}'(k) \bullet e^{-j\omega ckT}$, and in that a quotient is formed in the phase detector from the real part $g_r$ and the imaginary part $g_i$ and is converted by means of an arc tan conversion $\varphi(k) =$ arc tan $g_i/g_r$ or an arc cotan conversion $\varphi(k) =$ arc ctg $g_r/g_i$.

5.  Method according to one of the preceding claims, characterized in that the complex coefficients $\underline{h}(k)$ are derived from a filter with real coefficients $h(k)$.

6.  Method according to one of the preceding claims, characterized in that a constant element which is present in the demodulated signal with a phase increment $w(k)$ is used to control the frequency $\omega_c$ for the carrier multiplication $\underline{g}(k) = \underline{g}'(k) \bullet e^{-j\omega ckT}$ to the correct value for the correct setting when the constant element disappears.

7.  Method according to one of the preceding claims, characterized in that the sampling frequency $f_A$ is halved in the complex bandpass filter, and in that the carrier frequency $f_c$ is equal to the halved output sampling frequency $f_{A'}$ ($f_c = f'_A/2 = f_A/4$), so that the carrier multiplication is carried out using $(-1)^k$.

8.  Method according to one of the preceding claims, characterized in that the phase increment $w(k)$ is supplied to a high-pass filter (HP).

9.  Method according to Claim 8, characterized in that the phase increment $w(k)$ is supplied to an equalizer (E).

10. Method according to one of the preceding claims, characterized in that bandpass or low-pass filtering is carried out before the analogue/digital conversion.

11. Method according to Claim 10, characterized in that the complex bandpass filter (CBF) has an FIR structure with a finite impulse response.

12. Method according to Claim 10, characterized in that the complex bandpass filter is a half-band filter CHBF, its filter mid-frequency $f_m$ being identical to a quarter of the sampling frequency $f_A$.

**Revendications**

1. Procédé de démodulation de signaux modulés en fréquence se présentant sous la forme

$$g(t) = a(t) \cdot \cos [\varphi(t)]$$

ayant la fréquence instantanée

$$\omega(t) = d\varphi(t)/dt = \omega_0[1 - \alpha \cdot v(t)]$$

le signal reçu $g_0(t)$ étant détecté à la fréquence de détection $f_A = 1/T$ pour

$$g_0(k) = a(k) \cdot \cos[\varphi(kT]$$

$$= a(k) \cdot \cos[\omega_0 \, kT + \psi(kT)],$$

avec

$$\varphi(k) \ \approx \ \Delta\Omega \ \cdot \ T \sum_{-\infty}^{k} v(k),$$

formule dans laquelle v(k) représente le signal transmis, k le nombre de pas, T la longueur de période de pas, $\Delta\Omega = \alpha \cdot \omega_0$ l'excursion de fréquence, $\omega_0 = 2\pi f_0$ la fréquence de référence et a(t) ou a(k) l'amplitude variant en fonction du temps t conditionné par la limitation de bande au chemin de transmission,
on filtre ($h_B$) pour obtenir $\underline{g}(kT)$ avec des filtres passe-bas pour supprimer des composantes de spectres non souhaitées,
on effectue une multiplication complexe

$$\Delta\underline{g}(k) = \underline{g}(k) \cdot \underline{g}^*(k\text{-}1)$$

$$= g_r(k) \cdot g_r(k\text{-}1) + g_i(k) \cdot g_i(k\text{-}1) + j[g_i(k) \cdot g_r(k\text{-}1) - g_r(k) \cdot g_i(k\text{-}1)]$$

$$= \Delta g_r(k) + j\Delta g_i(k) = e^{j[\Delta\omega \cdot T + \Delta\Omega \cdot T \cdot v(k)]}$$

(modulation avec temporisation),
et à l'aide d'un détecteur de phase (PD), on forme l'incrément de phase $w(k) = \omega_0 \cdot [1 + \alpha \cdot v(k)]$, souhaité, en partant de ce produit pour obtenir ainsi le ou les signaux v(k) à transmettre,
caractérisé en ce que
on soumet tout d'abord le signal reçu $g_0(kT)$ à un filtrage avec un filtre de bande,
ce filtre ayant des coefficients complexes $\underline{h}(k)$ (génération de la quadrature QE ; $\underline{g}'(k) = g_0(kT) \cdot \underline{h}(k)$), et
par une multiplication complexe de la porteuse $\underline{g}(k) = \underline{g}'(k) \cdot e^{-j\omega ckT}$, on effectue un déphasage vers f≈0, et on utilise les deux composantes de quadrature $g_r$ et $g_i$ de ce signal de réception $\underline{g}(k)$ complexe, décalé, pour la multiplication complexe $\underline{\Delta}$.

2. Procédé selon la revendication 1,
caractérisé en ce qu'
on forme le quotient entre la partie réelle et la partie imaginaire $g_r$, $g_i$ du produit complexe $\underline{g}(k)$ et on convertit ce quotient par une conversion $\arctan\Delta g_i/\Delta g_r$ ou une conversion arc-cotg pour obtenir l'incrément de phase w(k).

3. Procédé selon la revendication 1,
caractérisé en ce qu'
on détermine l'incrément de phase souhaité w(k) par un algorithme CORDIC, en utilisant la partie réelle et la partie imaginaire.

4. Procédé de démodulation de signaux modulés en fréquence, sous la forme

$$g(t) = a(t) \cdot \cos [\varphi(t)]$$

ayant la fréquence instantanée

$$\omega(t) = d\varphi(t)/dt = \omega_0[1 + \alpha \cdot v(t)]$$

selon lequel on détecte le signal reçu $g_0(t)$ à la fréquence de détection $f_A = 1/T$, donnant

$$g_0(k) = a(k) \cdot \cos[\varphi(kT]$$

$$= a(k) \cdot \cos[\omega_0 kT + \psi(kT)],$$

avec

$$\varphi(k) \approx \Delta\Omega \cdot T \sum_{-\infty}^{k} v(k),$$

formule dans laquelle v(k) représente le signal transmis, k le nombre de pas, T la longueur de période de pas, $\Delta\Omega = \alpha \cdot \omega_0$ l'excursion de fréquence, $\omega_0 = 2\pi f_0$ la fréquence de référence et a(t) ou a(k) l'amplitude variant en fonction du temps t, conditionné par la limitation de bande au chemin de transmission,
et à partir du signal de réception $g_0(k)$ reçu, on génère un signal de quadrature $\underline{g}(k)$ (QE),
puis, on filtre ($h_B$) pour obtenir $\underline{g}(kT)$ à l'aide d'un filtre passe-bas, pour supprimer les composantes spectrales non voulues, et
on applique le résultat à un détecteur de phase (PD) qui génère un signal de phase $\varphi(k)$,
et à partir de celui-ci, en formant la différence ($\underline{\Delta}$) on obtient le signal basse fréquence, modulé,

$$v(k) = \varphi(k) - \varphi(k-1)$$

caractérisé en ce que
on forme un signal de quadrature (QE) à partir du signal reçu, détecté $g_0(kT)$ tout d'abord en filtrant par un filtre de bande (CBF), ayant des coefficients de type complexe $\underline{h}(k)$, puis on effectue une multiplication complexe de la porteuse $\underline{g}(k) = \underline{g}'(k) \cdot e^{-j\omega ckT}$, pour réaliser un décalage de fréquence vers $f \approx 0$,
on forme un quotient de la partie réel $g_r$ et de la partie imaginaire $g_i$ dans le détecteur de phase, et
on transforme ce quotient par une conversion arc-tg $\varphi(k) = $ arc tan $g_i/g_r$ ou une conversion arc-cotg $\varphi(k) = $ arc cotg $g_r/g_i$.

5. Procédé selon l'une des revendications précédentes,
caractérisé en ce qu'
on déduit les coefficients de valeur complexe h(k) à partir d'un filtre à coefficient réel h(k).

6. Procédé selon l'une des revendications précédentes,
caractérisé en ce qu'
on utilise une partie égale dans le signal démodulé avec un incrément de phase w(k), pour régler la fréquence $\omega_c$ pour la multiplication de porteuse $\underline{g}(k) = \underline{g}'(k) \cdot e^{-j\omega ckT}$ à la valeur correcte, pour permettre un réglage correct lorsque disparaît la partie égale.

7. Procédé selon l'une des revendications précédentes,
caractérisé en ce qu'

on divise par deux la fréquence de détection $f_A$ dans le filtre de bande complexe et
on rend la fréquence de porteuse $f_c$ égale à la demi-fréquence de détection de sortie $f_A'$, ($f_c = f_A'/2 = f_A/4$), pour avoir une multiplication par $(-1)^k$ de la porteuse.

8. Procédé selon l'une des revendications précédentes,
   caractérisé en ce qu'
   on applique l'incrément de phase $w(k)$ à un filtre passe-haut (PH).

9. Procédé selon la revendication 8,
   caractérisé en ce qu'
   on applique l'incrément de phase $w(k)$ à un correcteur de distorsion (E).

10. Procédé selon l'une des revendications précédentes
    caractérisé en ce qu'
    avant la conversion analogique/numérique, on effectue un filtrage par passe-bande ou par passe-bas.

11. Procédé selon la revendication 10,
    caractérisé en ce que
    le filtre de bande, complexe, (CBF) a une structure FIR à réponse impulsionnelle finie.

12. Procédé selon la revendication 10,
    caractérisé en ce que
    le filtre de bande, complexe, est un filtre de demi-bande (CHBF) dont la fréquence médiane $f_m$ est identique à un quart de la fréquence de détection $f_A$.

FIG.1

FIG.1b

FIG.1c

FIG. 2

FIG. 3

FIG. 6

Fig.5

$$\underline{g}(kT) = g_r(kT) + j\,g_i(kT)$$

Fig. 4

13

**Fig. 1a**

g(k)     g̲(k)
Reell          Komplex
          d̲(k)

$e^{-j\,2\pi k\,fc/f_A}$     mit $fc \approx f_A/4$

**Fig.8**

g(k)     d̲(k)     Δd̲(k)     v(k)

komplexes
Signal
d̲(k)     φ(k)     v(k): Demodul
                    NF (MPX)-
g(k)                 signal

FM-Signal

$F_A = 1/T$

**Fig. 7 :**   Blockstruktur FM-Demulator

PD : Phasendetektor

Δ : Differenzbildung : φ(k) - φ(k-1)